# EUROPEAN PATENT SPECIFICATION

(11) **EP 0 361 971 B1**
(45) Date of publication and mention of the grant of the patent: **30.11.1994**
(21) Application number: 89310010.7
(22) Date of filing: 29.09.1989
(51) Int. Cl.: H01R 23/68, H01R 9/09

(54) **Electrical connector**
Elektrischer Steckverbinder
Connecteur électrique

(30) Priority: 30.09.1988 JP 128738/88
(43) Date of publication of application: 04.04.1990
(73) Proprietor: MOLEX INCORPORATED, Lisle Illinois 60532 (US)
(72) Inventor: Enomoto, Masahiro, Tokyo (JP); Fukushima, Minoru, Yokohama (JP); Ooya, Masaaki, Yokohama (JP)
(74) Representative: Greenwood, John David

(56) References cited:
- EP-A- 0 142 952
- US-A- 2 740 097
- US-A- 4 486 066

## Description

The present invention relates to electrical connectors, and concerns electrical connectors for use in interconnecting conductors on printed circuit boards.

As is well known, various kinds of electrical connectors have been developed for electrically interconnecting conductors on printed circuit boards. See for ex. documents US-A- 2 740 097 and EP-A- 0 142 952.

One such electrical connector comprises a plurality of elongate terminal bodies. The terminal bodies are disposed in parallel at a predetermined pitch with their respective end portions inserted through and supported by separate right and left holders. The end portions of the terminal bodies protrude from bottom surfaces of the holders and the protruding end portions of the terminal bodies are configured as terminal pins which are adapted for insertion through through-holes of the printed circuit board or boards. One row of the terminal pins supported on one of the holders is inserted into one row of through-holes of a printed circuit board and are soldered thereto. Then, in the similar manner, the other row of terminal pins supported on the other of the holders is inserted into another row of the through-holes of the or another printed circuit board and are soldered thereto. In this way, conductors on the printed circuit board or boards are electrically connected together by use of the electrical connector.

In this type of prior art electrical connector, the terminal bodies and more specifically the intermediate terminal portions of the terminal bodies which extend between the holders are constructed to be flexible in nature and usually have linear configurations prior to the insertion of their terminal pins in circuit board through-holes. During the insertion operation of the rows of terminal pins, one row of terminal pins is first inserted into a row of through-holes of one printed circuit board and soldered thereto. Thereafter, the other row of terminal pins is inserted into a further row of through-holes of the printed circuit board or a row of through-holes of another printed circuit board and soldered thereto. At this time, the terminal bodies being flexible are bent to suit the relative positions of the one and the other rows of through-holes whereby the connector is adapted to make the required electrical connection between conductors on the printed circuit board or boards irrespective of their relative position.

Although the electrical connectors according to the prior art are useful for electrically connecting conductors on printed circuit boards, there still remains the need for improving them in view of the tedious operation of individually inserting the one and other rows of terminal pins into the one and other rows of through-holes in the printed circuit board or boards. In other words,
1) According to the design of prior art electrical connectors as stated above, a row of terminal pins of the terminal bodies supported by one of the connector holders is first inserted into a row of through-holes of, say, one printed circuit board and soldered thereto, and then after the terminal bodies between the holders have been bent to suit the position of a selected row of through-holes of another printed circuit board, the other row of terminal pins of the terminal bodies supported by the other connector holder are inserted into the selected row of through-holes of said other printed circuit board and soldered thereto. Therefore, two positioning operations of the one and the other rows of terminal pins with respect to their through-holes of the circuit boards must individually be performed, thereby increasing the number of insertion steps and the insertion time;
2) As stated above, before insertion of each row of the terminal pins into each row of the through-holes of the printed circuit boards, precise positioning of each row of the terminal pins relative to the through-holes must be done. However, because there is no guide means for positioning the terminal pins in the prior art connectors, it may happen that reliable insertion of the terminal pins fails to occur in one movement and it takes a longer period of time to insert the terminal pins into the through-holes of the circuit boards. This becomes more significant especially in the case where the terminal pins and the through-holes are of small size, the pitch of the terminal pins arranged side by side is small, and the distance between the rows of the terminal pins to be inserted through through-holes is short; and
3) Recently, such type of insertion operations tends to be automatically performed by a robot. Such an automatic insertion operation, however, becomes more and more complicated because the one and the other insertion operation must be performed individually as stated above.

The present invention beginning with a prior art electrical connector as described above is improved according to the features defined in the characterising portion of claim 1.

At the time both rows of the terminal pins are to be inserted into the respective rows of printed circuit board through-holes, the present invention provides that mechanism is actuated to move the holders towards one another and into abutment with stop means which positions the holders with the terminal pin rows at spacing "T", thereby enabling simultaneous insertion of both rows of said terminal pins into both rows of printed circuit board through-holes.

In use of an electrical connector of the invention, in accordance with the invention, before both rows of terminal pins are inserted into the respective rows of printed circuit board through-holes, the terminal bodies are kept in their expanded, i.e. non-deflected, state due to their restoring elastic forces so that the distance "S" between the two rows of terminal pins is made greater than the interval "T" between the two rows of through-holes of the printed circuit board. Thus, in order to insert both rows of the terminal pins into the respective rows of circuit board through-holes the shape maintaining intermediate portions of the terminal bodies are deflected by means of, e.g. a pair of right and left members which move to squeeze the connector holders against an intervening stop member. In other words, the pair of right and left holders of the connector are moved towards each other by a suitable mechanism, thereby decreasing the spacing between both rows of terminal pins until the oppositely facing adjacent walls of the two connector holders abut against the stop member. At this time, the distance "S" between both rows of terminal pins matches with the interval "T" as defined above. Thereafter, simply depressing the entire electrical connector towards the printed circuit board enables easy and reliable insertion of both rows of terminal pins into both rows of through-holes of the printed circuit board in one operation. Thereafter, the terminal pins are soldered to the associated conductors on the printed circuit board to achieve the electrical connection therebetween.

Of course, the flexible characteristics of the terminal bodies can be utilized to make electrical connections between the conductors on two different printed circuit boards irrespective of their relative positions.

It is to be understood from the foregoing that the present invention includes the apparatus for positioning both rows of the terminal pins of a connector of the invention so that the distance between them matches with the interval between two rows of printed circuit board through-holes, thereby enabling the precise, rapid and simultaneous insertion of both rows of the terminal pins into both rows of the through-holes of a printed circuit board, e.g. by means of an automatic insertion by a robot.

Some ways of carrying out the present invention will now be described in detail by way of example with reference to drawings in which:
FIG. 1 is a top plan view of an electrical connector according to the present invention;
FIG. 2 is a cross-sectional view taken along the line X-X′ in Fig. 1 showing a step before the terminal pins of the terminal bodies arranged in two parallel rows are inserted into their associated printed circuit board through-holes which are also arranged in two parallel rows;
FIG. 3 is a side view of the electrical connector shown in Fig. 1 as viewed from the right hand side thereof;
FIG. 4 is a cross-sectional view similar to Fig. 2 but representing a state after the terminal pins of the terminal bodies have been inserted into the associated printed circuit board through-holes.
FIG. 5 shows a further embodiment of electrical connector according to the present invention; and
FIGS. 6 and 7 show two examples of the use of an electrical connector of the invention electrically connecting two printed circuit boards to each other.

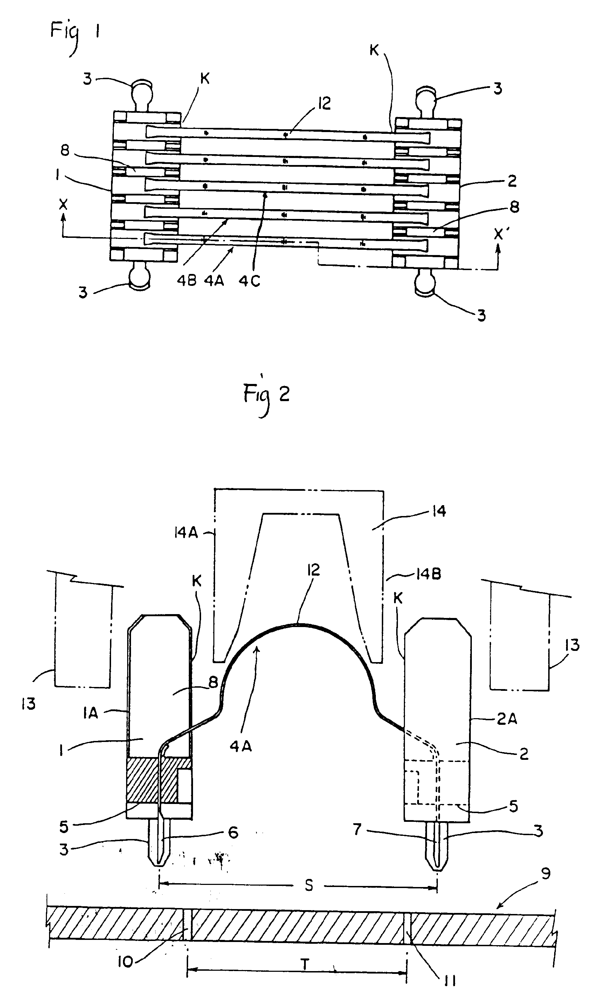

With reference now to the drawings, reference numerals 1 and 2 denote a set of right and left holders in the form of separately formed mold members. The holders 1 and 2 have lock pieces 3 integrally formed on their front and rear ends, respectively. A plurality of terminal bodies 4A, 4B, 4C ....... each consisting of an elongate flexible plate member are disposed in parallel at a predetermined pitch between the holders 1 and 2. More particularly, with reference to the terminal body 4A, one end of the terminal body 4A is inserted through and supported in one holder 1. As shown in Fig. 2, this end of the terminal body 4A protrudes beyond the bottom surface 5 of the holder 1 and forms one terminal pin 6. Similarly, the other end of the terminal body 4A is inserted through and supported in the other holder 2. Said other end of the terminal body also protrudes beyond the bottom surface 5 of the holder 2 and forms a terminal pin 7. As a consequence, both ends 6 and 7 of the terminal bodies 4A, 4B, 4C ..... are constructionally reinforced by their associated holders 1 and 2 and present terminal pins.

In addition, with reference to the parallel arrangement of the terminal bodies 4A, 4B, 4C ...... , partition walls 8 of the holders 1 and 2 are integrally formed between portions of the holders 1 and 2 on which the terminal bodies 4A, 4B, 4C ...... are supported. A printed circuit board is represented by the reference numeral 9 and is provided with two rows of through-holes 10 and 11 into which said terminal pins 6 and 7 are to be inserted, and with lock holes (not shown) into which said lock pieces 3 are to be fitted. It is to be noted that in Fig. 2, only one of each row of the through-holes 10 and 11 is shown, but a plurality of these through-holes 10 and 11 are actually provided in parallel rows.

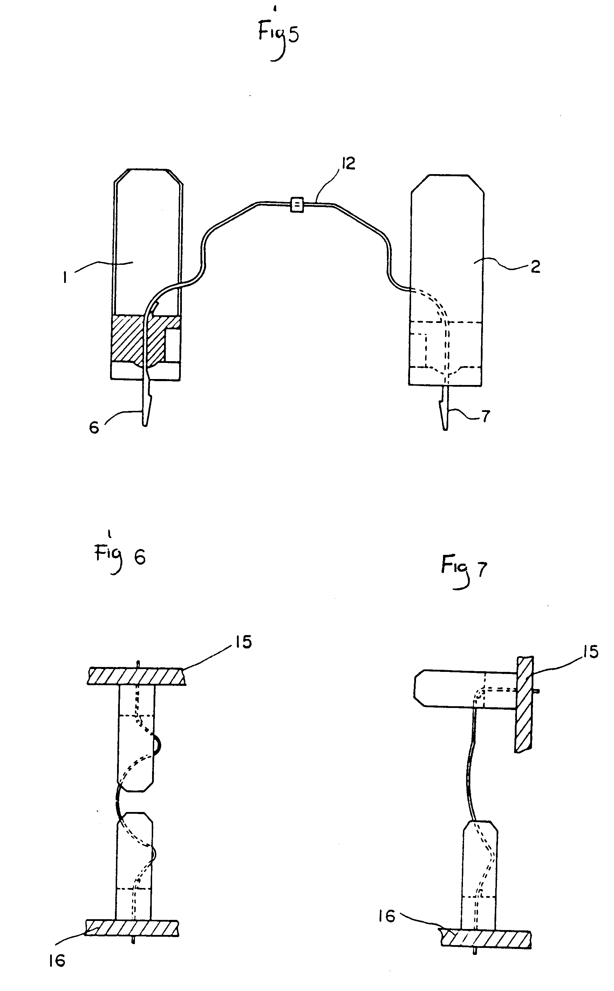

Assuming that "T" is the interval between the rows of through holes 10 and 11 and "S" is the distance between the two rows of terminal pins 6 and 7 prior to the insertion of the terminal pins 6 and 7 into the through-holes 10, 11, then the connector is constructed such that the relation S > T can be maintained. More particularly, terminal pins 6 are held approximately perpendicular to the printed circuit board 9 in order to insert the terminal pins 6 into the through-holes 10 in one row. And at the same time, the terminal pins 7 are also held approximately perpendicular to the circuit board 9 so that the terminal pins 7 can be inserted into the through-holes 11 in the other row. However, said relations S > T can still be maintained due to the restoring resilience of portions 12 of the terminal bodies supported between the holders 1 and 2. Thus, the portions 12 of the terminal bodies are formed as shape maintaining, semi-circular portions. Alternatively, the portions 12 of the terminal bodies may have a shape maintaining shape as shown in Fig. 5 or they may have a shape maintaining inverted-V-shape or a shape maintaining M-shape for example. A pair of chuck jaws 13 is provided for squeezing the portions 12 of the terminal bodies in a predetermined manner, and a stop member 14. The chuck jaws 13 are disposed at the outside of the pair of holders 1 and 2 and are operated to abut against the side walls 1A and 2A of the holders 1 and 2 and bring the holders closer together, thereby reducing the spacing between the holders 1 and 2, which causes the shaped portions 12 of the terminal bodies to deflect whereby the distance S between the rows of terminal pins 6 and 7 is decreased. However, in order to limit the squeezing effect of the chuck jaws 13, the stop member 14 having stop walls 14A and 14B is disposed between the pair of holders 1 and 2. The stop member 14 is so dimensioned that when the distance "S" between the rows of terminal pins 6 and 7 becomes equal to the distance "T" between the rows of through-holes 10 and 11, the stop walls 14A and 14B of the stop member 14 abut respectively against the opposite walls K of the holders 1 and 2, thereby limiting any further squeezing effect of the chuck jaws 13.

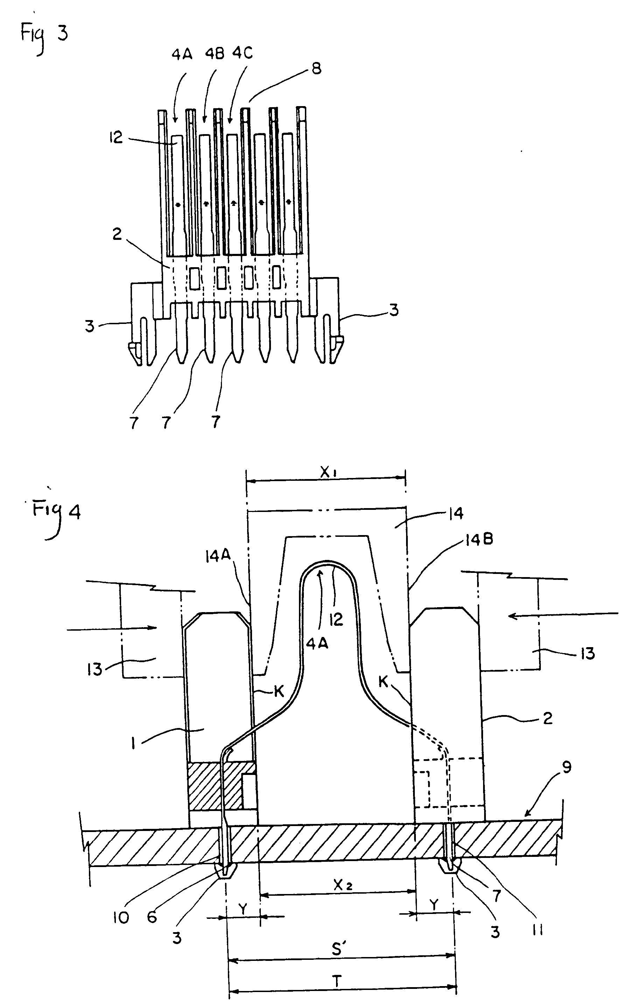

An electrical connector constructed according to Figs. 1 to 3 is installed as follows.

In the unmounted condition of the electrical connector, the distance "S" between the terminal pins 6 and 7 is made greater than the interval "T" between the rows of through-holes 10 and 11 of the printed circuit board 9 into which the pins are to be inserted due to the restoring elasticity of the portions 12 of the terminal bodies 4A, 4B, 4C .... . When the electrical connector is to be mounted on the printed circuit board 9, the terminal pins 6 and 7 of the connector are positioned facing directly towards the printed circuit board 9 as shown in Fig. 2. Then, the pair of chuck jaws 13 and the stop member 14 are advanced and the jaws 13 are actuated before performing the step of inserting the terminal pins 6 and 7 into the rows of through-holes 10 and 11 of the circuit board 9. More precisely, the chuck jaws 13 are abutted against the side walls 1A and 2A of the mold members 1 and 2, and thereafter, the squeezing action of the chuck jaws 13 moves the holders 1 and 2 towards one another, thereby reducing the distance between the holders 1 and 2 and thus resiliently deforming the portions 12 of the terminal bodies. Eventually, the stop walls 14A and 14B of the stop member 14 come into engagement with opposite walls K of the holders 1 and 2, and this limits the squeezing action of the chuck jaws. At this time, the distance "S′" between the terminal pins 6 and 7 of the terminal bodies becomes equal to the interval "T" between the rows of through-holes 10 and 11 of the printed circuit board 9. This enables the simultaneous smooth insertion of the terminal pins 6 and 7 of all the terminal bodies 4A, 4B, 4C .... into the through-holes 10 and 11 of the printed circuit board 9 simply by pressing the holders 1 and 2 downwards. Thereafter, the terminal pins 6 and 7 can be soldered to the conductors on the printed circuit board 9.

Selection of the stop member 14 is effected as follows. The values of "T" and "S′" as well as "Y" which is the distance between the walls K of the mold members 1 and 2 and the centers of the terminal pins 6 and 7 are initially known. Thus the spacing X2 between the opposite walls K of the holders 1 and 2 is obtained by subtracting 2"Y" from "S′" which equals to "T". Accordingly, it is easy to select the most suitable stop member 14 whose width "X1" is equal to the spacing "X2". In other words, before mounting the electrical connector on the printed circuit board, the stop member 14 is selected according to the interval "T" between the rows of through-holes 10 and 11 of the printed circuit board 9. Further, the stop member 14 must have such a shape that prevents the engagement of the stop member 14 with the portions 12 of the terminal bodies when they are subjected to the squeezing action of the chuck jaws 13 because at such time, the stop walls 14A and 14B of the stop member 14 are required to abut against the opposite walls K of the holders 1 and 2.

Figs. 6 and 7 show other applications of the present electrical connector whereby two printed circuit boards 15 and 16 are electrically connected with one another due to the deformability of the terminal bodies 4A, 4B, 4C ..... that can be deflected to accommodate different relative positions of both printed circuit boards 15 and 16. In this regard, the electrical connector can be adaptable to a wide range of printed circuit boards provided that the interval "T" between through-holes of the boards is less than the shape maintaining distance "S" between the terminal pins 6 and 7 formed at the ends of the terminal bodies.

Thus it is apparent from the foregoing that the present invention provides several advantageous effects as stated below.
1) Both terminal pin rows of the terminal bodies can be inserted simultaneously into both rows of printed circuit board through-holes so that effectively the insertion operation of a connector can be achieved in one stroke;
2) In such an insertion operation both rows of terminal pins of the terminal bodies can be guided precisely into the respective rows of through-holes of printed circuit board, thereby achieving precise and rapid positioning and thus insertion of an electrical connector;
3) An automatic insertion operation of a connector by a robot mechanism can easily be realized;
4) An electrical connector according to the present invention can be adapted to any type of printed circuit board irrespective of the interval between its rows of through-holes provided therein for insertion of the terminal pins of the terminal bodies; and
5) An electrical connector according to the present invention has a simple construction which enables economical manufacturing and easy use of the connector.

The invention extends to an electrical connector as described and shown having a single terminal body and a single pair of terminal pins for insertion in a single pair of printed circuit board through-holes.

## Claims

1. An electrical connector for interconnecting conductors on a printed circuit board (9) or boards comprising a plurality of elongate terminal bodies (4A, 4B, 4C...) disposed in parallel with respective end portions thereof held by separate right and left holders (1, 2), the end portions of the terminal bodies protruding from bottom surfaces of the holders (1, 2), the protruding portions being configured as terminal pins (6, 7) adapted for insertion through through-holes (10, 11) of the printed circuit board or boards, characterised in that:
the terminal bodies include intermediate portions (12) extending between the holders (1, 2) having a shape maintaining capacity so that the terminal pins (6, 7) are spaced by a predetermined distance (S) greater than the interval (T) between the rows of printed circuit board through-holes (10, 11) in which the terminal pins (6, 7) are to be inserted, the intermediate portions (12) being resiliently deflectable to enable said distance (S) to be matched to said interval (T).

2. An electrical connector as claimed in claim 1 in which said intermediate portions (12) of the terminal bodies (4A, 4B, 4C...) are of circular arch shape or inverted-V-shape or M-shape.

3. A method of installing an electrical connector as claimed in claim 1 or 2 on a printed circuit board (9) or boards comprising positioning the connector with its terminal pin rows perpendicular to the printed circuit board (9) or boards, actuating a mechanism to move at least one of the holders (1) of the connector towards the other (2) and into abutment with stop means (14A, 14B) to position the holders (1, 2) with said terminal pin rows over the printed circuit board through-hole rows in which the terminal pins (6, 7) are to be inserted and thereafter advancing the connector to insert the terminal pins (6, 7) in the circuit board through-holes (10, 11).

## Patentansprüche

1. Elektrischer Verbinder zur Verbindung von Leitern auf einer gedruckten Leiterplatte (9) oder -platten, bestehend aus einer Mehrzahl langgestreckter Anschlußkörper (4A,4B,4C...) in paralleler Anordnung mit jeweiligen, von einem gesonderten rechten und linken Halter (1,2) gehaltenen Endbereichen, wobei die Endbereiche der Anschlußkörper von der unteren Oberfläche der Halter (1,2) vorstehen und die vorstehenden Bereiche als Anschlußstifte (6,7) gestaltet sind, geeignet zum Einsetzen durch Durchgangslöcher (10,11) der gedruckten Leiterplatte oder -platten, dadurch gekennzeichnet, daß
die Anschlußkörper zwischen den Haltern (1,2) verlaufende Zwischenbereiche (12) mit formwahrender Eigenschaft aufweisen, derart, daß die Anschlußstifte (6,7) mit einem vorbestimmten Abstand (S) beabstandet sind, der größer ist als der Zwischenraum (T) zwischen den Reihen von Leiterplattendurchgangslöchern (10,11), in die die Anschlußstifte (6,7) einzusetzen sind, und die Zwischenbereiche (12) zur Ermöglichung einer Anpassung des Abstandes (S) an den Zwischenraum (T) elastisch auslenkbar sind.

2. Elektrischer Verbinder nach Anspruch 1, bei dem die Zwischenbereiche (12) der Anschlußkörper (4A,4B,4C...) eine Kreisbogenform, eine Form eines umgekehrten V oder M-Form besitzen.

3. Verfahren zum Installieren eines elektrischen Verbinders nach Anspruch 1 oder 2 auf einer gedruckten Leiterplatte (9) oder -platten, darin bestehend, daß der Verbinder mit seinen Anschlußstiftreihen senkrecht zu der gedruckten Leiterplatte (9) oder -platten positioniert wird, ein Mechanismus betätigt wird, um zumindest einen der Halter (1) des Verbinders zu dem anderen (2) hin und in Anlage mit Anschlagmitteln (14A,14B) zu bewegen, um die Halter (1,2) mit den Anschlußstiftreihen über den Leiterplattendurchgangslochreihen zu positionieren, in die die Anschlußstifte (6,7) einzusetzen sind, und danach der Verbinder zum Einsetzen der Anschlußstifte (6,7) in die Leiterplattendurchgangslöcher (10,11) vorbewegt wird.

## Revendications

1. Connecteur électrique pour l'interconnexion de conducteurs sur une carte (9) ou des cartes à circuit imprimé comprenant une pluralité de corps de bornes de forme allongée (4A, 4B, 4C, ...) disposés en parallèle par rapport à leurs parties d'extrémité maintenues par des supports séparés droite et gauche (1, 2), les parties d'extrémité des corps de bornes faisant saillie des surfaces inférieures des supports (1, 2), les parties en saillie étant configurées comme des broches de bornes (6, 7) adaptées pour l'insertion dans des trous traversants (10, 11) de la carte ou des cartes à circuit imprimé, caractérisé en ce que:
les corps de bornes comportent des parties intermédiaires (12) s'étendant entre les supports (1, 2) ayant une possibilité de maintien de la forme de telle sorte que les broches de bornes (6, 7) sont espacées d'une distance prédéterminée (S) supérieure à l'intervalle (T) entre les rangées de trous traversants (10, 11) de la carte à circuit imprimé dans lesquels les broches de bornes (6, 7) doivent être insérées, les parties intermédiaires (12) pouvant être déformées de façon élastique pour permettre à ladite distance (S) de correspondre audit intervalle (T).

2. Connecteur électrique selon la revendication 1 dans lequel lesdites parties intermédiaires (12) des corps de bornes (4A, 4B, 4C, ...) ont la forme d'un arc circulaire ou la forme d'un V inversé ou la forme d'un M.

3. Procédé d'installation d'un connecteur électrique selon la revendication 1 ou 2 sur une carte (9) ou des cartes à circuit imprimé comprenant le positionnement du connecteur avec ses rangées de broches de bornes perpendiculaires à la carte (9) ou aux cartes à circuit imprimé, l'actionnement d'un mécanisme pour déplacer au moins l'un des supports (1) du connecteur vers l'autre (2) et pour venir buter contre des moyens d'arrêt (14A, 14B) afin de positionner les supports (1, 2) avec lesdites rangées de broches de bornes sur les rangées de trous traversants de la carte à circuit imprimé dans lesquels les broches de bornes (6, 7) doivent être insérées, puis l'avance du connecteur pour insérer les broches de bornes (6, 7) dans les trous traversants (10, 11) de la carte à circuit imprimé.
